# EUROPEAN PATENT APPLICATION

(11) **EP 1 150 350 A2**
(43) Date of publication of application: **31.10.2001**
(21) Application number: 01301640.7
(22) Date of filing: 23.02.2001
(51) Int. Cl.: H01L 21/8242

(54) **Manufacturing a trench capacitor**

(30) Priority: 25.02.2000 US 513582
(71) Applicant: Infineon Technologies North America Corp., San Jose, CA 95112 (US); International Business Machines Corporation, Armonk, NY 10504 (US)
(72) Inventor: Jammy, Rajarao, Wappingers Falls, New York 12590 (US); Schroeder, Uwe, Fishkill, New York 12524 (US); Wong, Kwong Hon, Wappingers Falls, New York 12590 (US)
(74) Representative: Vigars, Christopher Ian

(57) **Abstract**

A trench capacitor structure comprising a buried electrode about a trench, said trench being formed in a semiconductor substrate, a node dielectric lining said trench at said buried electrode and trench electrode formed on said node dielectric, said node dielectric comprising a diffusion barrier and a high dielectric constant dielectric such as rutile phase TiO₂ is provided. A method of fabricating such a trench structure is also provided, said method comprising (a) providing a semiconductor substrate having at least one trench formed therein, said at least one trench being defined by a trench wall; (b) forming a buried electrode in said semiconductor substrate about at least a portion of said trench wall; (c) forming a diffusion barrier on said trench wall over at least a portion of said buried electrode; (d) forming a dielectric material having a high dielectric constant, e.g., rutile phase TiO₂, on said diffusion barrier; and (e) forming a first conductive layer on said high k dielectric, said first conductive layer forming a trench electrode.

## Description

### Field of the Invention

The present invention relates to a trench capacitor structure, and more particular to a trench capacitor structure in which a stable, high dielectric constant, k, dielectric material such as rutile TiO₂ or another high dielectric constant metal oxide is employed as the node dielectric material in a trench storage cell of an advanced memory device such as a dynamic random access memory (DRAM) device. The present invention also relates to a method of fabricating the same. The terms "high dielectric constant" or "high k" denote a dielectric material that has a dielectric constant higher than Si₃N₄, i.e., higher than 7.

### Background of the Invention

In the field of trench storage capacitors, Si₃N₄/SiO₂ (NO) or SiO₂/Si₃N₄/SiO₂ (ONO) are typically employed as node dielectric materials with doped or undoped polysilicon being employed as the trench electrode. Such node materials generally have an effective dielectric constant of less than 7. However, as the technical field approaches the use of 1 Gb and higher memory cell densities, the effective dielectric constants of SiO₂ and Si₃N₄ pose some serious problems in terms of storing adequate charge. To offset this potential charge loss in future dynamic random access memory (DRAM) cells, it has been proposed to etch a deeper trench or to reduce the thickness of the dielectric layers. In the case of stacked capacitors, taller storage cylinders have been developed to overcome the potential charge loss. None of the above proposals, however, are particularly desirable. For instance, etching a deeper trench would cause increased processing time and costs whereas scaling down the dielectric film thickness tends to increase the leakage through the node dielectric due to tunneling.

As an alternative to employing the above relatively low dielectric constant materials in advanced memory devices, higher dielectric constant materials containing metal oxides such as tantalum pentoxide (Ta₂O₅) and barium strontium titanate (BSTO) have been targeted for use in stacked capacitors. The use of higher dielectric constant materials is disclosed, for example, in U.S. Patent No. 4,432,035 to Hsieh, et al.; U.S. Patent No. 4,464,701 to Roberts, et al.; U.S. Patent No. 5,362,632 to Mathews; IBM Technical Disclosure Bulletin, Vol. 26, No. 10B, March 1984 pp. 5527-5529, entitled "Formation of Thermally Stable Ta₂O₅ Films", Journal of Electrochemical Society: Solid-State and Technology, pp. 1405-1410, July 1986; IBM Technical Disclosure Bulletin, Vol. 32, No. 4B, September 1989, pp. 343-344 entitled "Process for Fabricating Small High Value Capacitors"; and the article to Roberts, et al. entitled "Deposition and Properties of Ultra-Thin High Dielectric Constant Insulators", Emerging Semiconductor Technology, ASTM STP 960, D.C. Gupta & P. H. Langer, Eds. Amer. Soc. for Testing Materials, 1986, pp. 137-149.

High dielectric constant materials/structures (k>7) are desirable for trench dielectric applications to enhance the capacitance in DRAM cells. Increased capacitance is desired for a number of reasons including retention time enhancement, manageable capacitor dimensions (trench depth) and a path to shrinking the overall dimensions of the trench storage technology for increasing density on a chip.

Despite the current development of such high dielectric constant materials in advanced memory applications, those materials suffer the following drawbacks. First, when used as a thin film (<30 nm), the above mentioned high dielectric constant metal oxide materials exhibit high leakage currents. Secondly, the prior art high dielectric constant materials exhibit polarization fatigue which means that there is a decrease in ability to switch between "write" and "read" states. Moreover, the electrode formation used in conjunction with the prior art metal oxide-based dielectrics may become too costly as precious metals such as platinum and iridium are implemented.

Another well known but rarely used high dielectric constant material is TiO₂. Although TiO₂ has been previously investigated, it is necessary to use a high temperature (650°C or greater) oxidation step to form a high k rutile phase TiO₂ material. Under such high temperature oxidation conditions, Ti, however, reacts with Si to form silicide which contributes to excessive leakage of the trench storage capacitor. Thus, prior art structures containing rutile TiO₂ tend to be unstable.

Typically, at lower oxidation temperatures, anatase or brookite phases dominate. The anatase and brookite phases of TiO₂ have dielectric constants of less than 3 and are semiconducting or insulating; therefore they are not suitable for use as a node dielectric material. Another complication with employing TiO₂ as the node dielectric material is the uncontrollable formation of oxide under the Ti on Si substrates, resulting in excessive leakage or loss of capacitance.

In view of the drawbacks mentioned above, there is a continued need for developing new and improved structures in which rutile TiO₂ and other high k dielectric materials can be easily implemented into a trench storage capacitor without forming silicides or without causing excessive leakage, while still maintaining an acceptable capacitance.

### Summary of the Invention

The present invention relates to an improved trench capacitor structure and to a method of fabricating the same, wherein the trench capacitor structure has a high overall capacitance as compared to today's state-of-the-art technology. The improved trench capacitor structure of the present invention contains a high k dielectric material, preferably rutile TiO₂, as a node dielectric material without exhibiting the prior art problems of silicide formation or excessive leakage loss. These prior art problems have been substantially alleviated in the present invention by using a thin (35 A or less) diffusion barrier material (e.g., nitrides, oxynitrides and oxides) about the trench walls of the trench capacitor.

Specifically, the trench capacitor structure of the present invention comprises a buried electrode about a trench, said trench being formed in a semiconductor substrate, a node dielectric lining said trench at said buried electrode and a trench electrode formed on said node dielectric, said node dielectric comprising a diffusion barrier material such as a nitride, oxynitride or oxide, and a high k dielectric layer. In a highly preferred embodiment of the present invention, the high k dielectric is a rutile phase TiO₂ layer. In other embodiments, the high k dielectric is another metal oxide compound such as, but not limited to: Al₂O₃, Ta₂O₅, La₂O₃, RuO₂, etc.

The present invention also relates to a method of fabricating the above-mentioned trench capacitor structure, said method comprising the steps of:
(a) providing a semiconductor substrate having at least one trench formed therein, said at least one trench being defined by a trench wall;
(b) forming a buried electrode in said semiconductor substrate about at least a portion of said trench wall;
(c) forming a diffusion barrier on said trench wall over at least a portion of said buried electrode;
(d) forming a high dielectric constant dielectric layer, preferably a rutile phase TiO₂ layer, on said diffusion barrier;
(e) forming a first conductive layer on said high dielectric constant dielectric layer, said first conductive layer forming a trench electrode; and
(f) optionally, filling said trench with a second conductive material.

The stable, high k dielectric material layer is obtained in the present invention by forming a suitable metal-containing pre-layer and then oxidizing the same. In the case of rutile phase TiO₂, that layer is obtained in the present invention by depositing Ti from TiCl₄, TiI₄, TiBr₄, organometallic compounds of Ti or another Ti-containing precursor and then employing an oxidation step which is capable of converting the same into the rutile phase or, alternatively, the rutile phase can be obtained by direct deposition of TiO₂. One structure of the present invention which contains the rutile TiO₂ phase as the node dielectric has a dielectric constant of at least about 50.

### Brief Description of the Drawings

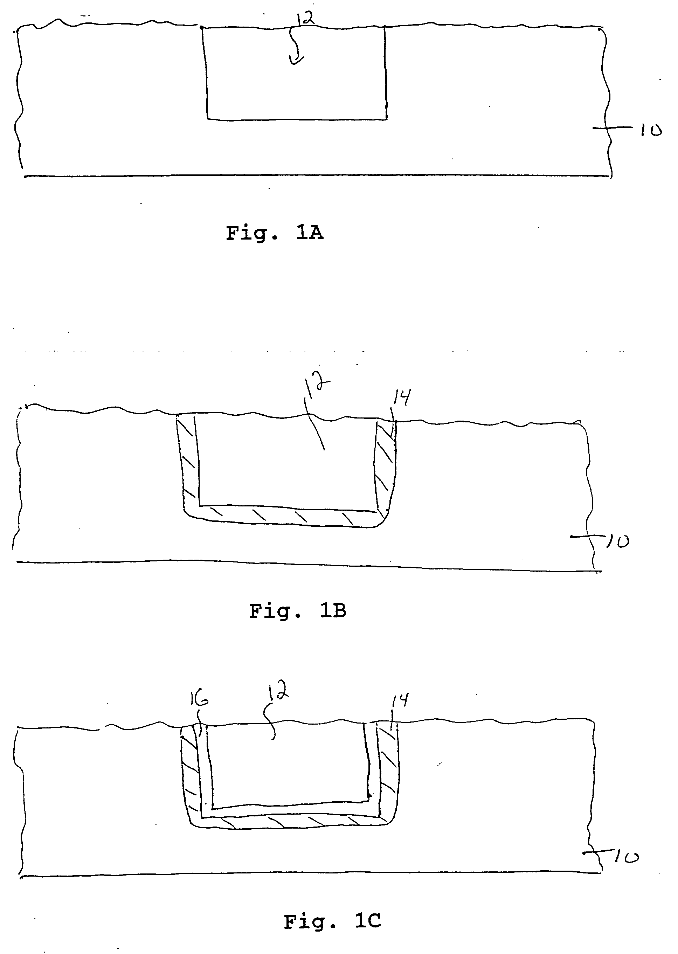

Figs. 1A-F are cross-sectional views showing the basic processing steps that are employed in the present invention for providing a trench capacitor structure in which a stable, high k, rutile TiO₂ node dielectric material has been incorporated into the structure.

### Detailed Description of the Invention

The present invention which provides an improved trench capacitor structure having a stable, high k dielectric such as rutile TiO₂, as the node dielectric and a method of fabricating the same will now be described in greater detail by referring to the drawings that accompany the present application. It should be noted that in the accompanying drawings like and corresponding elements are referred to by like reference numerals.

Although the detailed description that follows hereinbelow is specific for forming a node dielectric containing rutile TiO₂, that description is applicable for forming a node dielectric containing other high k dielectric materials such as, but not limited to: metal oxides such as Al₂O₃, ZrO₂, HfO₂, Ta₂O₅ and La₂O₃ as well as metal oxides that are doped with silicates.

Reference is first made to Fig. 1A which illustrates a cross-sectional view of a lower portion of an initial trench capacitor structure comprising a semiconductor substrate 10 and a trench 12 having trench walls (sidewalls and bottom walls); the top portion of the initial trench capacitor structure, which would include a pad oxide layer and a pad nitride layer formed on the surface of substrate 10, is not shown herein.

The structure shown in Fig. 1A is fabricated using conventional techniques that are well known in the art. For example, trench 12 is formed in semiconductor substrate 10 by conventional lithography and etching. The lithography process employs the use of a patterned photoresist, while the etching process may be carried out by reactive-ion etching (RIE), ion beam etching or plasma etching. After etching the trench in the semiconductor substrate, the patterned photoresist is stripped from the structure utilizing conventional stripping means well known to those skilled in the art.

Although the drawings of the present invention depict the presence of only one trench, the present invention also contemplates structures in which a plurality of trenches are formed in the semiconductor substrate. The configuration of the trench is not limited to any specific kind; therefore, the trench may have the configuration depicted in the drawings or other configurations such as bottle-shaped trenches are also contemplated herein.

When a bottle-shaped trench (definable by a narrow neck region as compared to a broader lower portion) is desired, it can be fabricated using conventional techniques that are well known to those skilled in the art. For example, the bottle-shaped trench structure can be fabricated using the processes disclosed in U.S. Patent Nos. 4,649,625 to Lu; 5,658,816 to Rajeevakumar; and 5,692,281 to Rajeevakumar, the contents of each being incorporated herein by reference.

The semiconductor substrates employed in the present invention comprise conventional semiconducting materials including, but not limited to: Si, Ge, SiGe, and all other Si-containing semiconductors. The substrate may also be composed of a layered semiconductor such as Si/SiGe. The semiconductor substrate may be of the n-type or p-type depending on the desired device to be fabricated. The substrate may contain various active and/or isolation regions either formed on the substrate or formed in the substrate using processing techniques that are well known in the art. These active/isolation regions are not shown in the drawings of the present invention. A preferred substrate employed in the present invention is a Si wafer or chip.

Following trench formation, buried electrode 14 is formed in semiconductor substrate 10 about at least a portion of the trench walls, see Fig. 1B. The buried electrode is formed using conventional processes well known in the art which are capable of diffusing the appropriate conductivity type dopant through the trench wall. One technique that can be used in the present invention forming the buried electrode is described, for example, in U.S. Patent No. 5,395,786, the content of which is incorporated herein by reference.

After formation of the buried electrode, a diffusion barrier 16 (which functions herein as a liner material) is formed on the trench walls over at least a portion of buried electrode 14, see Fig. 1C. Diffusion barrier 16 is formed using a conventional deposition process including, but not limited to: chemical vapor deposition (CVD), plasma-assisted CVD, sputtering and other like deposition processes or, alternatively, the diffusion barrier is formed by a thermal growing process. The thickness of diffusion barrier 16 may vary depending on the specific process used in forming the same, but typically diffusion barrier 16 is a thin layer having a thickness of from about 5 about 35 A. It is noted that the diffusion barrier should be sufficiently thin so as not to substantially reduce the capacitance of the device, but thick enough to prevent excessive leakage of stored charges.

Diffusion barrier 16 is composed of any conventional material which can function as a barrier layer in trench storage capacitors. Illustrative examples of some typical materials that can be used as diffusion barrier 16 include, but are not limited to: nitrides such as Si₃N₄, TiN and TiAlN; oxynitrides and oxides. Of these materials, it is preferred that Si₃N₄ be employed in the present invention as the diffusion barrier.

Other alternative approaches can also be used in forming the diffusion barrier. For example, the diffusion barrier can be formed by depositing a metal whose oxide is conducting like Ru, Ir or SrRu as a liner material, deposit TiN and thereafter oxidize. During the oxidation of TiN, the underlying metal is also oxidized and forms part of the electrode. In this scheme, a Si₃N₄ barrier is optional.

Although not shown in the drawings of the present invention, an oxide collar may be formed in the top portion of trench 12 following the formation of diffusion barrier 16 using techniques well known in the art. For example, the oxide collar may be formed by recessing the diffusion barrier and then employing local oxidation of silicon (LOCOS).

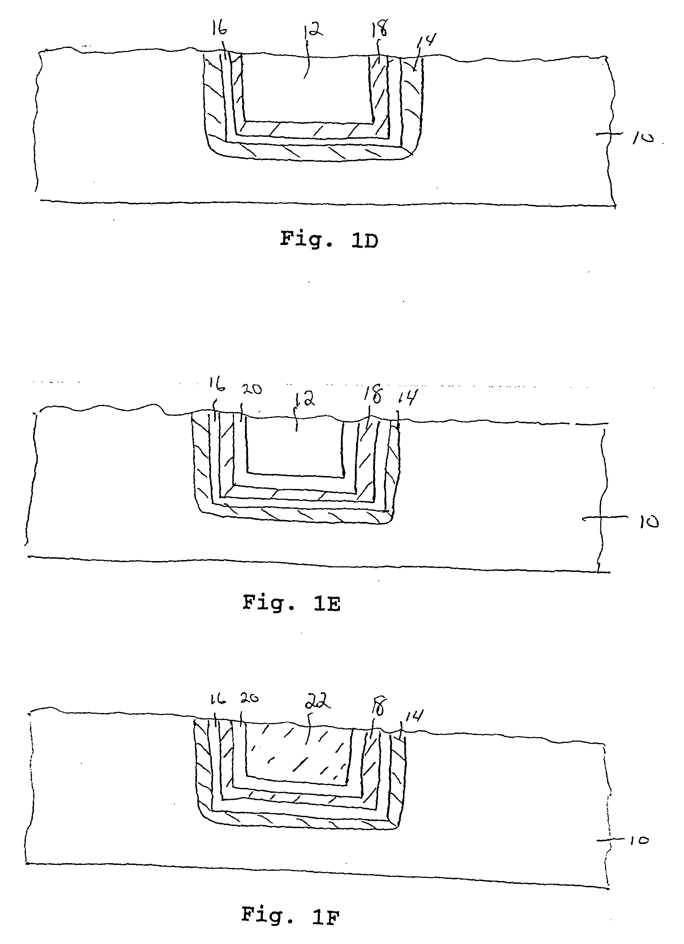

Next, as shown in Fig. 1D, a rutile phase TiO₂ layer 18 (or other high k dielectric material) is formed on diffusion barrier 16. The rutile phase TiO₂ layer (or other high k dielectric layer) may be formed by direct deposition of TiO₂ (or other appropriate metal oxide) using a Ti-containing precursor such as Ti, TiCl₄, TiI₄, TiBr₄, TiN, TiO₂ or an organometallic Ti-containing compound such as Ti isopropoxide or Ti methoxide (or other appropriate metal-containing precusor). First a pre-layer of the same material may be formed and then the resultant pre-layer is exposed to an oxidation step which is capable of converting the Ti-containing precursor to a rutile TiO₂ phase. In the case of other high k dielectrics, the oxidation step is carried out under conditions effective in converting the metal-containing pre-layer to a high k dielectric.

When TiO₂ (or other metal oxide) is directly deposited, a low pressure chemical vapor deposition (LPCVD) process may be employed. Oxidation is optional when the deposition process is carried out a temperature of about 650°C or greater. If the deposition temperature is below 650°C, the TiO₂ layer (or other metal oxide layer) may be subjected to an oxidation, as defined hereinbelow. By "low pressure" it is meant, a deposition pressure of about 100 Torr or below. When a Ti-containing pre-layer (or other metal-containing pre-layer) is deposited, any conventional deposition process including: CVD, plasma-assisted CVD, sputtering, evaporation and the like, may be employed. Following deposition of the Ti-containing pre-layer (or other metal-containing pre-layer), the resultant pre-layer is exposed to an oxygen-containing atmosphere, e.g., air or oxygen, at temperatures of from about 350°C or higher for a time period sufficient in converting the pre-layer into a high k dielectric material. Preferred conditions include: a temperature of 650°C or higher and a time period of about 5 seconds or greater. The desired oxidation time may vary depending on the desired thickness of the resultant high k dielectric material. For example, if a 50 A or greater dielectric is desired, the oxidation time is about 30 seconds or more in a rapid thermal process tool; however, if less than 50 A is desired, the oxidation time is less than 30 seconds. In the practice of the present invention, the oxidation time is typically at least about 15 seconds. In one embodiment, the oxidation step is carried out at a temperature of from about 400° to about 1000°C for a time period of from about 10 to about 3600 seconds. Other oxidation temperatures and times can however be employed in the present invention. Also furnace processing can be employed in which case the temperature and time may change.

The final thickness of the rutile TiO₂ layer (or other high k dielectric material), which is not critical to the present invention, depends on the initial layer employed. In one embodiment, the rutile TiO₂ layer together with the diffusion barrier form the node dielectric of the trench capacitor structure which separates the buried electrode from the trench electrode. The rutile TiO₂ layer (or other high k dielectric) formed in the present invention is stable, i.e., no silicide formation occurs or no uncontrollable interfacial oxide forms under the high k dielectric layer. Moreover, the rutile TiO₂ layer of the present invention has a high dielectric constant associated therewith. The term "high dielectric constant" when used in conjunction with the rutile phase material denotes a k value of at least 50 (the k of the combined rutile TiO₂ and diffusion barrier is thus at least 30 or above). In the case of the other high k dielectrics, the method of the present invention forms a dielectric material that has a dielectric constant of above 7.

Next, as is shown in Fig. 1E, first conductive layer 20 is formed over high k dielectric layer 18. First conductive layer 20 is formed using conventional deposition processes well known in the art, including: CVD, atomic layer CVD, plasma-assisted CVD and sputtering, and it is composed of any suitable conductive material including, but not limited to: nitride-containing materials such as TiN, WN, TaSiN; conducting oxides; elemental metals such as W, Pt, Re, Ru and the like; as well as other like conductive materials whose resistivity is from about 1 to about 1000 µohm-cm. One highly preferred first conductive layer employed in the present invention is TiN. First conductive layer 20 forms the trench electrode of the trench capacitor structure of the present invention.
Following trench electrode formation, the remaining portions of trench 12 may optionally be filled with a suitable second conductive material 22 such as, but not limited to: doped amorphous silicon; metal oxides; elemental metals such as Ru, Ir, W, TiN, Cr; and silicides of said metals. The optional second conductive material may be formed utilizing conventional deposition processes such as CVD and plasma-assisted CVD and, if required, doping may be carried out in-situ during the deposition process or after using a conventional ion implantation process and an activation anneal. The structure after conducting this optional step of the present invention is shown in Fig. 1F.

The structure of Fig. 1E or 1F is then subjected to conventional processing steps that complete the fabrication of the trench capacitor structure. These additional processing steps for completing the trench capacitor structure are well known in the art; therefore, a detailed description of the same is not provided herein.

In a preferred embodiment of the present invention, the upper portion of the structure shown in Fig. 1F is recessed using conventional techniques in order to form a region for the formation of a buried-strap. Specifically, the recessing is carried out by first planarizing the structure using conventional planarization techniques such as chemical-mechanical polishing or chemical etching which are capable of removing second conductive material 22 down to first conductive layer 20. After planarization, layers 20 and 18 are removed stopping at diffusion barrier 16. This removal process is carried out utilizing any conventional anisotropic or isotropic etching process. Alternatively, a combination of anisotropic and isotropic etching may be used to remove the various material layers from the upper region of the trench. Examples of suitable etching techniques that can be employed in the present invention, include: ion enhanced etching, ion induced etching, plasma etching, reactive-ion etching, reactive-ion beam etching, chemical down stream etching, microwave plasma etching, chemical etching, wet etching or other like etching techniques. The removal of layers 20 and 18 is preferably performed by wet chemical etching.

After removing layers 20 and 18 from the upper portion of the trench, diffusion barrier 16 is removed utilizing a conventional etch process which employs an etchant that is highly selective in removing the barrier layer as compared to Si. An illustrative example of one preferred etchant that can be employed in the present invention in removing diffusion barrier 16 is a mixture of HF and glycerol.

In one embodiment, the present invention contemplates to minimize the possibility of workfunction mismatches by a careful selection of top electrode in the trench structure (metal's, conductive metal oxides, metal nitrides and metal silicides). Additionally, TiN at high temperatures can form Ti silicides which can also be used as the trench electrode of the trench capacitor. It is noted that the processing steps of the present invention overcome the loss of capacitance to depletion as is typically observed in current technology with Si₃N₄/SiO₂ capacitors.

The capacitor structures of the present invention may be used in DRAM memory cells or in other integrated circuit devices. Specifically, the memory cell of the present invention may comprise the capacitor structure shown in Fig. 1E or 1F as well as a n-band region, a p-well, a shallow trench isolation region, a buried-strap region, an array implant, a gate conductor and an array conductor region.

The memory cell device may be fabricated utilizing the method of the present invention in combination with other manufacturing steps to form shallow trench isolations, gate conductor regions and other memory cell components; these other manufacturing steps are well known to those skilled in the art.

In addition to memory cells and the manufacture thereof, the capacitor structures and manufacturing techniques of the present invention may also be useful in conjunction with other integrated device structures and device manufacturing techniques.

While this invention has been particularly shown and described with respect to preferred embodiments thereof, it will be understood by those skilled in the art that the foregoing and other changes in forms and details may be made without departing from the spirit and scope of the present invention. It is therefore intended that the present invention not be limited to the exact forms and details described and illustrated, but fall within the scope of the appended claims.

## Claims

1. A trench capacitor structure formed in a semiconductor substrate, said trench capacitor structure comprising a buried electrode about a trench, said trench being formed in a semiconductor substrate, a node dielectric lining said trench at said buried electrode and a trench electrode formed on said node dielectric, said node dielectric comprising a diffusion barrier and a dielectric material having a dielectric constant of 7 or greater

2. The trench capacitor structure of Claim 1 wherein said semiconductor substrate is composed of a semiconducting material selected from the group consisting of Si, Ge, SiGe and layered semiconductors.

3. The trench capacitor structure of Claim 2 wherein said semiconductor substrate is a Si chip or wafer.

4. The trench capacitor structure of Claim 1 wherein a plurality of trenches are formed in said semiconductor substrate.

5. The trench capacitor structure of Claim 1 wherein said diffusion barrier of said node dielectric is composed of a nitride, oxynitride or oxide.

6. The trench capacitor structure of Claim 5 wherein said diffusion barrier is a nitride.

7. The trench capacitor structure of Claim 1 wherein said dielectric material is rutile phase TiO₂, Al₂O₃, ZrO₂, HfO₂, Ta₂O₅, La₂O₃ or other like oxide material.

8. The trench capacitor structure of Claim 7 wherein said dielectric material is rutile phase TiO₂.

9. The trench capacitor structure of Claim 1 wherein said trench electrode is composed of a first conductive material having a resistivity of from about 1 to about 1000 µohm-cm.

10. The trench capacitor structure of Claim 9 wherein said first conductive material is a metal, metallic nitride, metallic silicide or a metallic oxide.

11. The trench capacitor structure of Claim 10 wherein said first conductive material is a metallic nitride selected from the group consisting of TiN, WN and TaSiN.

12. The trench capacitor structure of Claim 1 further comprising a second conductive material formed on said trench electrode.

13. The trench capacitor structure of Claim 12 wherein said second conductive material formed on said trench electrode is doped amorphous silicon.

14. The trench capacitor structure of Claim 1 further comprising a collar oxide formed in an upper portion of said trench.

15. The trench capacitor structure of Claim 1 wherein said buried electrode is an out-diffused buried plate.

16. A memory cell device comprising at least the trench capacitor structure of Claim 1.

17. A method of fabricating a trench capacitor structure in a semiconductor substrate, said method comprising the steps of:
(a) providing a semiconductor substrate having at least one trench formed therein, said at least one trench being defined by a trench wall;
(b) forming a buried electrode in said semiconductor substrate about at least a portion of said trench wall;
(c) forming a diffusion barrier on said trench wall over at least a portion of said buried electrode;
(d) forming a dielectric material having a dielectric constant of 7 or above on said diffusion barrier; and
(e) forming a first conductive layer on said dielectric material, said first conductive layer forming a trench electrode.

18. The method of Claim 17 further comprising filling said trench with a second conductive material.

19. The method of Claim 17 wherein said at least one trench is formed by lithography and etching.

20. The method of Claim 17 wherein said buried electrode is formed by out-diffusion.

21. The method of Claim 17 wherein said diffusion barrier is formed by a thermal growing process or a deposition process selected from the group consisting of chemical vapor deposition (CVD), plasma-assisted CVD and sputtering.

22. The method of Claim 17 wherein said diffusion barrier has a thickness of from about 5 to about 35 A.

23. The method of Claim 17 wherein said diffusion barrier is composed of a nitride, oxynitride or oxide.

24. The method of Claim 22 wherein said diffusion barrier is a nitride.

25. The method of Claim 17 wherein said dielectric material is rutile phase TiO₂, Al₂O₃, ZrO₂, HfO₂, Ta₂O₅, La₂O₃ or other like oxide material.

26. The method of Claim 25 wherein said dielectric material is rutile phase TiO₂.

27. The method of Claim 17 wherein said dielectric material having a dielectric constant of 7.0 or above is formed by directed deposition of a metal oxide or by deposition of a metal-containing precursor and oxidation.

28. The method of Claim 27 wherein said direct deposition is carried out using low pressure chemical vapor deposition at a temperature of about 350°C or greater.

29. The method of Claim 27 wherein said dielectric material is rutile TiO₂ and said Ti-containing precursor is selected from the group consisting of Ti, TiCl₄, TiO₂, TiI₄, TiBr₄, TiN and organometallic compounds of Ti.

30. The method of Claim 27 wherein said oxidation is carried out in an oxygen-containing atmosphere at a temperature of about 650°C or greater and for a time period of about 5 seconds or greater.

31. The method of Claim 30 wherein said oxidation is carried out at a temperature of from about 400° to about 1000°C for a time period of from about 10 to about 3600 seconds.
